# EUROPEAN PATENT APPLICATION

(11) **EP 4 669 047 A1**
(43) Date of publication of application: **24.12.2025**
(21) Application number: 25184135.9
(22) Date of filing: 20.06.2025
(51) Int. Cl.: H05K 7/20

(54) **SYSTEMS AND METHODS FOR IMPROVING COOLING CONTROL OF ARTIFICIAL INTELLIGENCE LOADS**

(30) Priority: 21.06.2024 US 202463662534 P; 18.06.2025 US 202519241531
(71) Applicant: Vertiv Corporation, Westerville, OH 43082 (US)
(72) Inventor: BUSH, Terry, Westerville (US); SCHUTTE, Daniel J., Lewis Center (US); HEBER, Brian P., Lewis Center (US)
(74) Representative: Cousens, Nico

(57) **Abstract**

A method for cooling components responsive to artificial intelligence loads includes: measuring, using at least one electrical component, a power demand value of an artificial intelligence load; learning an artificial intelligence load pattern based on the power demand value; communicating the artificial intelligence load pattern via a communications link; receiving, at a coolant distribution unit, the artificial intelligence load pattern via the communications link; and controlling cooling of the artificial intelligence load based on the artificial intelligence load pattern.

## Description

This U.S. Non-Provisional Patent Application claims the benefit of U.S. Provisional Patent Application Serial No. 63/662,534, filed June 21, 2024.

### TECHNICAL FIELD

This disclosure relates to artificial intelligence, and, in particular, to systems and methods for improving cooling control of artificial intelligence loads.

### BACKGROUND

There are multiple important operational features of any cooling system, including providing the proper amount of cooling, such that the temperature is well maintained. This can be a supplied air temperature, the temperature of a supply or return fluid (e.g., such as air, water or refrigerant), or the temperature of a cold plate or heatsink. However, an equally important requirement is to prevent excessive cycling of components like compressors, pumps, fan motors, and valve positions. This has a significant impact on reliability or life of the system.

In the past, the typical data center cooling demand over a short period of time has been relatively constant. Although load changes do occur, they are usually not large changes and are infrequent, happening at most a few times per day. Cooling system controls are designed for this type of scenario and perform best with steady state loads, while still responding properly to load changes when they do occur.

### SUMMARY

An aspect of the disclosed embodiment includes a system for cooling components responsive to artificial intelligence loads. The system includes at least one electrical component configured to: measure, using a coolant distribution unit, a power demand value of an artificial intelligence load; learn an artificial intelligence load pattern based on the power demand; and selectively instruct a cooling component to cool the artificial intelligence load based on the artificial intelligence load pattern.

Another aspect of the disclosed embodiments includes a system for cooling components responsive to artificial intelligence loads. The system includes at least one electrical component configured to: measure a power demand value of an artificial intelligence load; learn an artificial intelligence load pattern based on the power demand value; and communicate the artificial intelligence load pattern via a communications link. The system also includes a coolant distribution unit that includes a processor and a memory. The memory includes instructions that, when executed by the processor, cause the processor to: receive the artificial intelligence load pattern via the communications link; and control cooling of the artificial intelligence load based on the artificial intelligence load pattern.

Another aspect of the disclosed embodiments includes a method for cooling components responsive to artificial intelligence loads. The method includes: measuring, using at least one electrical component, a power demand value of an artificial intelligence load; learning an artificial intelligence load pattern based on the power demand value; communicating the artificial intelligence load pattern via a communications link; receiving, at a coolant distribution unit, the artificial intelligence load pattern via the communications link; and controlling cooling of the artificial intelligence load based on the artificial intelligence load pattern.

### BRIEF DESCRIPTION OF THE DRAWINGS

The above and/or other aspects will become apparent and more readily appreciated from the following description of example embodiments, taken in conjunction with the accompanying drawings, in which:
FIG. 1 is an example of an artificial intelligence load, according to the principles of the present disclosure.
FIG. 2 is a schematic diagram of electrical power distribution equipment coupled to cooling equipment for a rack PDU embodiment, according to the principles of the present disclosure.
FIG. 3 is a schematic diagram of electrical power distribution equipment coupled to cooling equipment for a power shelf embodiment, according to the principles of the present disclosure.
FIG. 4 generally illustrates a cooling system response to artificial intelligence loads, according to the principles of the present disclosure.
FIG. 5 is a flow diagram generally illustrating a method for cooling components responsive to artificial intelligence loads according to the principles of the present disclosure.

### DETAILED DESCRIPTION

Reference will now be made in detail to example embodiments which are illustrated in the accompanying drawings, wherein like reference numerals refer to like elements throughout. In this regard, the example embodiments may have different forms and may not be construed as being limited to the descriptions set forth herein.

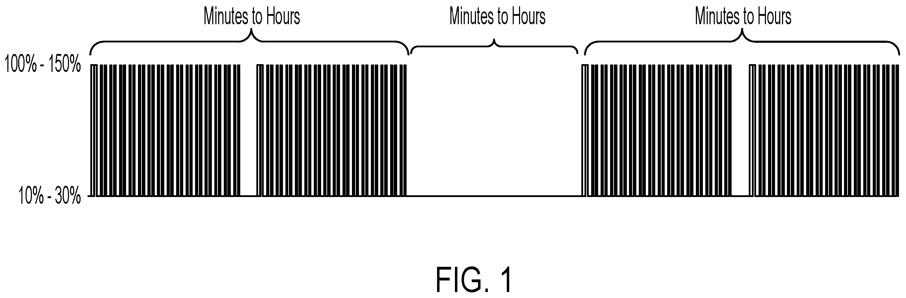

With the advent of artificial intelligence (AI), cooling demand has changed drastically. AI load changes can be large (e.g., 100% capacity or more) and occur very quickly and repeatedly. The load changes can be virtually any pattern including, for example, the AI load changes hundreds of times per minute for hours, and then drops to a small value for several minutes to hours. FIG. 1 is an example of one possible AI load pattern.

Cooling systems typically have a time lag in detecting cooling load changes. This can be created by inherent delays in temperature sensor response, fluid flow loop time, or thermal resistance lag of component being cooled. Since these delays can easily be much longer than the time between load changes, it is apparent that an AI load that changes hundreds of times per minute could cause cooling components to cycle on and off which would reduce their useful life.

Accordingly, systems and methods, such as those described herein, configured to provide improved cooling control for AI loads, may be desirable. In some embodiments, the systems and methods described herein may be configured to couple electrical equipment that measures the AI load (e.g., voltage, current, power, and the like) with a coolant distribution unit (CDU) that cools the AI load via a communications link. The CDU may include may include a processor and a memory. The processor may include any suitable processor. Additionally, or alternatively, the CDU may include any suitable number of processors. The memory may comprise a single disk or a plurality of disks (e.g., hard drives), and includes a storage management module that manages one or more partitions within the memory. In some embodiments, memory may include flash memory, semiconductor (solid state) memory or the like. The memory may include Random Access Memory (RAM), a Read-Only Memory (ROM), or a combination thereof. The memory may include instructions that, when executed by the processor, cause the processor to, at least, perform various functions described herein.

The electrical equipment my include any suitable electrical equipment, including, but not limited to, an uninterruptable power supply (UPS), a static transfer switch (STS), a rack power distribution unit (PDU), a power shelf, any other suitable electrical component, or a combination thereof. The electrical components, such as the UPS or other electrical component, learns the AI load pattern and communicates, via a communications link (e.g., comms) the forthcoming power demand to the CDU. The communications link may include any suitable communication system or device, and may include a wired or wireless communication mechanism and/or protocol. This gives the CDU time to change operating state to optimize the cooling delivered to the AI load. The CDU may change operating state to optimize the cooling delivered to the AI load based on the learned AI load pattern.

In some embodiments, systems and methods described herein may be configured to provide a high performing cooling system for AI systems. The systems and methods described herein may be configured to improve CDU efficiency, responsiveness, and useful operating life. The systems and methods described herein may be retrofitted for existing installations, using firmware updates, communications devices, and unit-to-unit wiring.

In critical data centers the load supported by a cooling system is also supported by an electrical power distribution equipment (e.g., UPS, STS, PDU, rack PDU, and/or the like) that are part of the data center powertrain. The systems and methods described herein may be configured to use the components of electrical equipment to measure the electrical power demand in real-time. The systems and methods described herein may be configured to, in response to a power change, use the electrical equipment to identify the power change before the cooling system measures a temperature change.

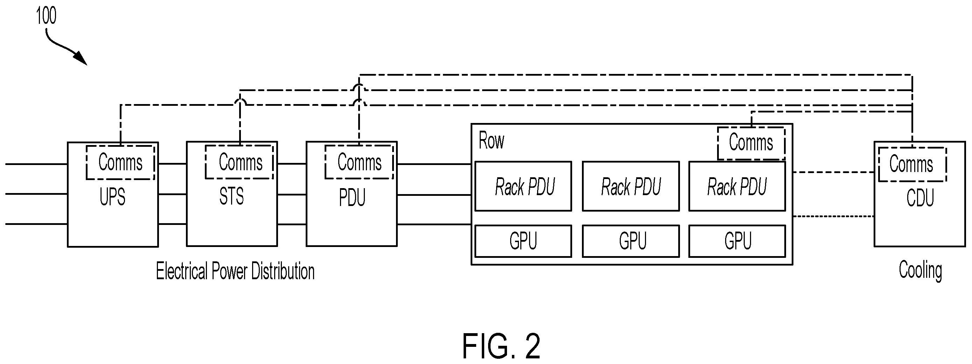

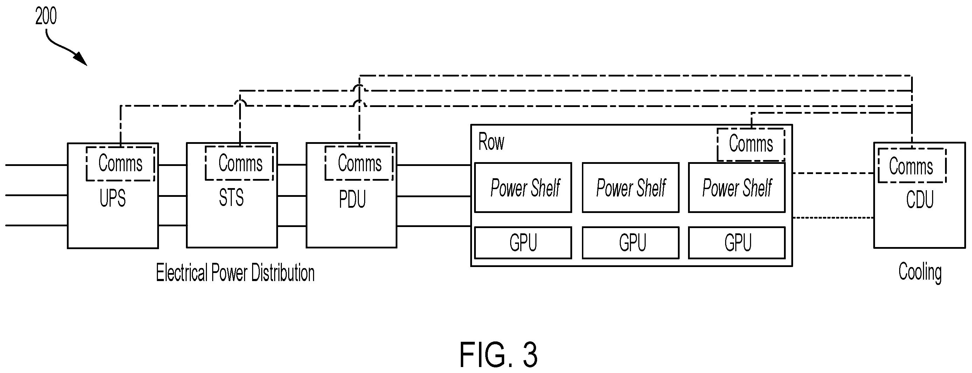

FIGS. 2 and 3 show close-coupling of electrical equipment with cooling equipment via a communications link, with FIG. 2 illustrating a system 100 that includes rack PDU that powers one or more graphics processor units (GPU) (e.g., the AI load), and FIG. 3 illustrating a system 200 that includes a power shelf.

Due to the physical nature of the special processors (e.g., GPUs) that execute AI processes and the AI processes themselves (e.g., typically involving training of large neural networks), AI loads often have a repeated pattern of load changes. The system 100 and/or the system 200 may be configured to, using the electrical equipment, store a history of the load changes and using, machine learning, determine the pattern. For example, during many AI training tasks, the same pattern can continue for hours, days or even weeks. The system 100 and/or the system 200 may be configured to use the electrical equipment to predict load changes (e.g., to a relatively large degree of accuracy). The system 100 and/or the system 200 may be configured to use the electrical equipment to communicate the information to the cooling system. The system 100 and/or the system 200 may be configured to use the cooling system to take advantage to affect better temperature control and prevent excessive component cycling that otherwise would not be possible with conventional control methods.

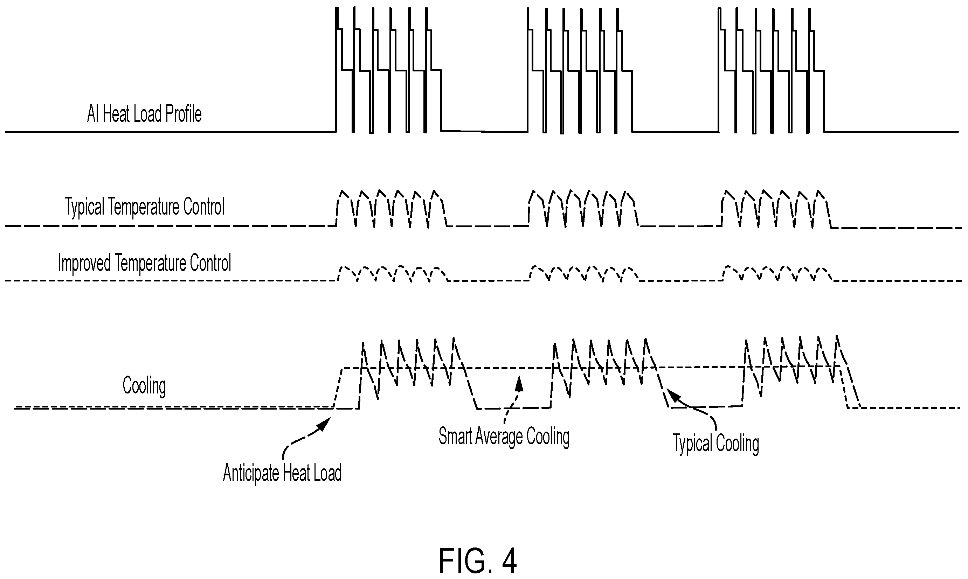

FIG. 4 illustrates an example heat load profile for AI loads. The pattern and period of real AI heat loads may vary in such a way that cooling performance is not affected significantly but a high likelihood exists that it will be negatively impacted in a major way. Lag in sensing temperature and cooling fluid loop delay can result in cooling overshoot/undershoot, poor temperature control and excessive component cycling.

The system 100 and/or the system 200 may be configured to use the cooling system to respond to sensed temperature as heat load changes. The cooling varies in a manner that results in less-than-optimal temperature control and cycling of components due to the rapidly changing heat load. The system 100 and/or the system 200 may be configured to control temperature by providing a constant cooling capacity according to the average heat load (e.g., which may result in less overshoot/undershoot resulting in better temperature control and minimized component cycling).

In some embodiments, the system 100 and/or the system 200 may be configured to use a close-coupled type system where the cooling unit is located close to the heat source (e.g., the servers). The system 100 and/or the system 200 may be configured to any suitable number of UPSs to feed the rack/row and 1 (N) cooling unit or (N+1) cooling units per rack/row. The system 100 and/or the system 200 may be configured to direct feedback from the UPS to the cooling unit to improve the cooling performance.

In some embodiments, the system 100 and/or the system 200 may be configured to use a plurality of electrical equipment components to feed the rack/row with a plurality of cooling units. The system 100 and/or the system 200 may be configured to provide cooling for a plurality of racks/rows. The system 100 and/or the system 200 may be configured to use the electrical equipment to aggregate the data for all the server loads and provide the data to the cooling units.

The system 100 and/or the system 200 may be configured to identify local 'hot spots' early, such that the local cooling unit (e.g., close in proximity to the hot spot) can anticipate the increased cooling demand prior to the heat traveling back to the cooling unit. The system 100 and/or the system 200 may be configured to use the anticipated cooling demand to reduce/eliminate the local hot spots, which may allow for an improved cooling profile to be provided for the data center.

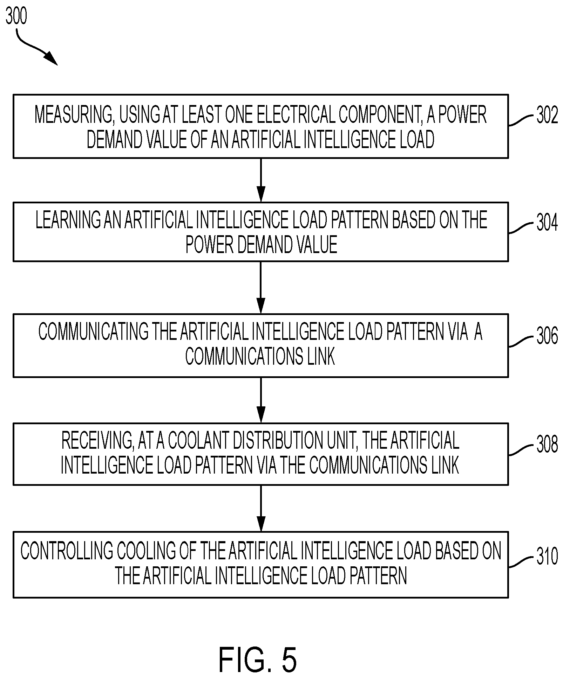

FIG. 5 is a flow diagram generally illustrating a method 300 for cooling components responsive to artificial intelligence loads. The system 100 and/or 200 may be configured to perform some or all portions of the methods described herein. For example, the system 100 and/or the system 20 may be configured to perform the steps of the method 300.

At 302, the method 300 measures, using at least one electrical component, a power demand value of an artificial intelligence load.

At 304, the method 300 learns an artificial intelligence load pattern based on the power demand value.

At 306, the method 300 communicates the artificial intelligence load pattern via a communications link.

At 308, the method 300 receives, at a coolant distribution unit, the artificial intelligence load pattern via the communications link.

At 310, the method 300 controls cooling of the artificial intelligence load based on the artificial intelligence load pattern.

In some embodiments, a system for cooling components responsive to artificial intelligence loads includes at least one electrical component configured to: measure a power demand value of an artificial intelligence load; learn an artificial intelligence load pattern based on the power demand value; and communicate the artificial intelligence load pattern via a communications link. The system also includes a coolant distribution unit that includes a processor and a memory. The memory includes instructions that, when executed by the processor, cause the processor to: receive the artificial intelligence load pattern via the communications link; and control cooling of the artificial intelligence load based on the artificial intelligence load pattern.

In some embodiments, the at least one electrical component includes an uninterruptable power supply. In some embodiments, the at least one electrical component includes a static transfer switch. In some embodiments, the at least one electrical component includes a rack power distribution unit. In some embodiments, the at least one electrical component includes a power shelf. In some embodiments, the power demand value includes a voltage value of the artificial intelligence load. In some embodiments, the power demand value includes a current value of the artificial intelligence load. In some embodiments, the power demand value includes a power value of the artificial intelligence load. In some embodiments, the artificial intelligence load includes at least one server computing device. In some embodiments, controlling cooling of the artificial intelligence load based on the artificial intelligence load pattern includes changing an operating state of the coolant distribution unit. In some embodiments, controlling cooling of the artificial intelligence load based on the artificial intelligence load pattern includes changing an amount of coolant delivered to the artificial intelligence load.

In some embodiments, a method for cooling components responsive to artificial intelligence loads includes: measuring, using at least one electrical component, a power demand value of an artificial intelligence load; learning an artificial intelligence load pattern based on the power demand value; communicating the artificial intelligence load pattern via a communications link; receiving, at a coolant distribution unit, the artificial intelligence load pattern via the communications link; and controlling cooling of the artificial intelligence load based on the artificial intelligence load pattern.

In some embodiments, the at least one electrical component includes an uninterruptable power supply. In some embodiments, the at least one electrical component includes a static transfer switch. In some embodiments, the at least one electrical component includes a rack power distribution unit. In some embodiments, the at least one electrical component includes a power shelf. In some embodiments, the power demand value includes a voltage value of the artificial intelligence load. In some embodiments, the power demand value includes a current value of the artificial intelligence load. In some embodiments, the power demand value includes a power value of the artificial intelligence load. In some embodiments, controlling cooling of the artificial intelligence load based on the artificial intelligence load pattern includes changing an operating state of the coolant distribution unit.

The above discussion is meant to be illustrative of the principles and various embodiments of the present disclosure. Numerous variations and modifications will become apparent to those skilled in the art once the above disclosure is fully appreciated. It is intended that the following claims be interpreted to embrace all such variations and modifications.

It will be understood that the terms "include," "including," "comprise," and/or "comprising," when used in this specification, specify the presence of stated features, integers, steps, operations, elements, and/or components, but do not preclude the presence or addition of one or more other features, integers, steps, operations, elements, components, and/or groups thereof.

It will be further understood that, although the terms "first," "second," "third," etc., may be used herein to describe various elements, components, regions, layers and/or sections, these elements, components, regions, layers and/or sections may not be limited by these terms. These terms are only used to distinguish one element, component, region, layer or section from another element, component, region, layer or section.

As used herein, the term "and/or" includes any and all combinations of one or more of the associated listed items. Expressions such as "at least one of," when preceding a list of elements, modify the entire list of elements and do not modify the individual elements of the list.

Various terms are used to refer to particular system components. Different companies may refer to a component by different names - this document does not intend to distinguish between components that differ in name but not function.

Matters of these example embodiments that are obvious to those of ordinary skill in the technical field to which these example embodiments pertain may not be described herein in detail.

It may be understood that the example embodiments described herein may be considered in a descriptive sense only and not for purposes of limitation. Descriptions of features or aspects within each example embodiment may be considered as available for other similar features or aspects in other example embodiments.

The word "example" is used herein to mean serving as an example, instance, or illustration. Any aspect or design described herein as "example" is not necessarily to be construed as preferred or advantageous over other aspects or designs. Rather, use of the word "example" is intended to present concepts in a concrete fashion. As used in this application, the term "or" is intended to mean an inclusive "or" rather than an exclusive "or". That is, unless specified otherwise, or clear from context, "X includes A or B" is intended to mean any of the natural inclusive permutations. That is, if X includes A; X includes B; or X includes both A and B, then "X includes A or B" is satisfied under any of the foregoing instances. In addition, the articles "a" and "an" as used in this application and the appended claims should generally be construed to mean "one or more" unless specified otherwise or clear from context to be directed to a singular form. Moreover, use of the term "an implementation" or "one implementation" throughout is not intended to mean the same embodiment or implementation unless described as such.

Implementations the systems, algorithms, methods, instructions, etc., described herein can be realized in hardware, software, or any combination thereof. The hardware can include, for example, computers, intellectual property (IP) cores, application-specific integrated circuits (ASICs), programmable logic arrays, optical processors, programmable logic controllers, microcode, microcontrollers, servers, microprocessors, digital signal processors, or any other suitable circuit. In the claims, the term "processor" should be understood as encompassing any of the foregoing hardware, either singly or in combination. The terms "signal" and "data" are used interchangeably.

As used herein, the term module can include a packaged functional hardware unit designed for use with other components, a set of instructions executable by a controller (e.g., a processor executing software or firmware), processing circuitry configured to perform a particular function, and a self-contained hardware or software component that interfaces with a larger system. For example, a module can include an application specific integrated circuit (ASIC), a Field Programmable Gate Array (FPGA), a circuit, digital logic circuit, an analog circuit, a combination of discrete circuits, gates, and other types of hardware or combination thereof. In other embodiments, a module can include memory that stores instructions executable by a controller to implement a feature of the module.

Further, in one aspect, for example, systems described herein can be implemented using a general-purpose computer or general-purpose processor with a computer program that, when executed, carries out any of the respective methods, algorithms, and/or instructions described herein. In addition, or alternatively, for example, a special purpose computer/processor can be utilized which can contain other hardware for carrying out any of the methods, algorithms, or instructions described herein.

Further, all or a portion of implementations of the present disclosure can take the form of a computer program product accessible from, for example, a computer-usable or computer-readable medium. A computer-usable or computer-readable medium can be any device that can, for example, tangibly contain, store, communicate, or transport the program for use by or in connection with any processor. The medium can be, for example, an electronic, magnetic, optical, electromagnetic, or a semiconductor device. Other suitable mediums are also available.

The above-described embodiments, implementations, and aspects have been described in order to allow easy understanding of the present disclosure and do not limit the present disclosure. On the contrary, the disclosure is intended to cover various modifications and equivalent arrangements included within the scope of the appended claims, which scope is to be accorded the broadest interpretation so as to encompass all such modifications and equivalent structure as is permitted under the law.

## Claims

1. A system for cooling components responsive to artificial intelligence loads, the system comprising:
at least one electrical component configured to:
measure a power demand value of an artificial intelligence load;
learn an artificial intelligence load pattern based on the power demand value; and
communicate the artificial intelligence load pattern via a communications link; and
a coolant distribution unit that includes a processor and a memory including instructions that, when executed by the processor, cause the processor to:
receive the artificial intelligence load pattern via the communications link; and
control cooling of the artificial intelligence load based on the artificial intelligence load pattern.

2. The system of claim 1, wherein the at least one electrical component includes an uninterruptable power supply.

3. The system of claim 1 or 2, wherein the at least one electrical component includes a static transfer switch.

4. The system of any preceding claim, wherein the at least one electrical component includes a rack power distribution unit.

5. The system of any preceding claim, wherein the at least one electrical component includes a power shelf.

6. The system of any preceding claim, wherein the power demand value includes a voltage value of the artificial intelligence load.

7. The system of any preceding claim, wherein the power demand value includes a current value of the artificial intelligence load.

8. The system of any preceding claim, wherein the power demand value includes a power value of the artificial intelligence load.

9. The system of any preceding claim, wherein the artificial intelligence load includes at least one server computing device.

10. The system of any preceding claim, wherein controlling cooling of the artificial intelligence load based on the artificial intelligence load pattern includes changing an operating state of the coolant distribution unit.

11. The system of any preceding claim, wherein controlling cooling of the artificial intelligence load based on the artificial intelligence load pattern includes changing an amount of coolant delivered to the artificial intelligence load.

12. A method for cooling components responsive to artificial intelligence loads, the method comprising:
measuring, using at least one electrical component, a power demand value of an artificial intelligence load;
learning an artificial intelligence load pattern based on the power demand value;
communicating the artificial intelligence load pattern via a communications link;
receiving, at a coolant distribution unit, the artificial intelligence load pattern via the communications link; and
controlling cooling of the artificial intelligence load based on the artificial intelligence load pattern.

13. The method of claim 12, wherein the at least one electrical component includes an uninterruptable power supply and/or a static transfer switch and/or a rack power distribution unit and/or a power shelf.

14. The method of claim 12 or 13, wherein the power demand value includes a voltage value of the artificial intelligence load and/or a current value of the artificial intelligence load and/or a power value of the artificial intelligence load.

15. The method of claim 12, 13 or 14, wherein controlling cooling of the artificial intelligence load based on the artificial intelligence load pattern includes changing an operating state of the coolant distribution unit.
